(19) Europäisches Patentamt
European Patent Office
Office européen des brevets

(11) EP 2 556 954 B1

(12) EUROPEAN PATENT SPECIFICATION

(45) Date of publication and mention of the grant of the patent:
**25.09.2019 Bulletin 2019/39**

(21) Application number: **11762728.1**

(22) Date of filing: **25.03.2011**

(51) Int Cl.:
***B32B 9/00*** *(2006.01)* ***C23C 14/48*** *(2006.01)*
***C23C 14/58*** *(2006.01)* ***H01B 5/14*** *(2006.01)*
***H01B 13/00*** *(2006.01)* ***C23C 14/56*** *(2006.01)*

(86) International application number:
**PCT/JP2011/057459**

(87) International publication number:
**WO 2011/122497 (06.10.2011 Gazette 2011/40)**

(54) **TRANSPARENT CONDUCTIVE FILM AND ELECTRONIC DEVICE USING TRANSPARENT CONDUCTIVE FILM**

TRANSPARENTER LEITENDER FILM UND ELEKTRONISCHE VORRICHTUNG MIT DEM TRANSPARENTEN LEITENDEN FILM

FILM CONDUCTEUR TRANSPARENT ET DISPOSITIF ÉLECTRONIQUE UTILISANT UN FILM CONDUCTEUR TRANSPARENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2010 JP 2010084522**

(43) Date of publication of application:
**13.02.2013 Bulletin 2013/07**

(73) Proprietor: **Lintec Corporation**
**Tokyo 173-0001 (JP)**

(72) Inventors:
- **NAGAMOTO, Koichi**
  **Tokyo 173-0001 (JP)**
- **KONDO, Takeshi**
  **Tokyo 173-0001 (JP)**
- **SUZUKI, Yuta**
  **Tokyo 173-0001 (JP)**
- **IWAYA, Wataru**
  **Tokyo 173-0001 (JP)**
- **NAGANAWA, Satoshi**
  **Tokyo 173-0001 (JP)**

(74) Representative: **Strehl Schübel-Hopf & Partner**
**Maximilianstrasse 54**
**80538 München (DE)**

(56) References cited:
**WO-A1-2010/021326**
**WO-A1-2010/107018**
**WO-A1-2010/107018**
**JP-A- 6 064 105**
**JP-A- 9 237 159**
**JP-A- 10 034 790**
**JP-A- 2006 070 238**
**JP-A- 2007 237 588**
**JP-A- 2008 204 683**
**JP-A- 2008 235 165**
**JP-A- 2008 270 115**
**JP-A- 2010 064 303**
**US-A- 5 907 382**

- **IWAMORI, S.; GOTOH, Y.; MOORTHI, K.: "Characterization of silicon oxynitride gas barrier films", VACUUM, vol. 68, 31 October 2002 (2002-10-31), pages 113-117, XP002703709, DOI: 10.1016/S0042-207X(02)00294-4**
- **CLARIANT: "AQUAMICA Hydrophilic Super Hard Coating", INTERNET CITATION, 4 November 2014 (2014-11-04), pages 1-12, XP002732000, Retrieved from the Internet: URL:http://www.probaf.co.kr/images/service /PRO%20GUARD%20GLASS%20COATING.pdf [retrieved on 2014-11-04]**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to a transparent conductive film which exhibits excellent gas barrier performance and transparency, to a production method therefor, and to an electronic device employing the transparent conductive film.

### Background Art

Polymer formed products of such as plastic film are inexpensive materials with high workability which have generally been used in a variety of fields. Before use, a function of interest is added to such a product depending on the purpose of use.

For example, film for wrapping foods or drugs is made of a gas barrier plastic film which prevents permeation of water vapor and oxygen, in order to prevent oxidation or denaturation of ingredients such as protein and oil and fat for maintaining the taste or freshness thereof.

In recent years, for the purpose of realizing reduction in thickness and weight, flexibility, etc., attempts have been made to replace a glass plate with a transparent plastic film serving as an electrode-substrate for display devices such as a liquid crystal display and an electroluminescence (EL) display. However, since plastic film is more permeable by water vapor, oxygen, or the like than glass plate, elements in a display device tend to be damaged, which is problematic.

In order to overcome the drawback, there has been proposed a flexible display substrate formed of a transparent plastic film on which a transparent gas barrier layer made of metal oxide is formed (see Patent Document 1).

However, the flexible display substrate disclosed in Patent Document 1 is produced by stacking a metal oxide transparent gas barrier layer on a transparent plastic film through vapor deposition, ion plating, sputtering, or a similar technique. Therefore, when the substrate is wound or bent, cracking occurs in the gas barrier layer, and gas barrier performance is problematically degraded.

There has been disclosed a method for producing a gas barrier stacked structure which is formed of a plastic film, and a polysilazane film which is formed on at least one surface of the plastic film and has been subjected to plasma treatment (see Patent Document 2).

However, in the above method, satisfactory gas barrier performance can be ensured only when the thickness of the gas barrier layer is adjusted to some microns, which is problematic. Specifically, Patent Document 2 discloses that water vapor permeability was 0.50 $g/m^2/day$, when the thickness of the gas barrier layer was 0.1 $\mu m$.

Meanwhile, in a transparent conductive film employing a transparent plastic substrate, ITO (tin-doped indium oxide) is used as a transparent conductive material. Since ITO contains indium, which is a rare metal, in recent years, a zinc oxide-based conductive material has been proposed as an ITO conductive material substitute. However, the sheet resistivity of a zinc oxide-based conductive material under moist and high-temperature conditions deteriorates more as compared with the case of ITO, which is also problematic.

Thus, one proposed means for solving the problem is a transparent conductive material having a plastic substrate sequentially coated with a hard coat layer and silicon-doped zinc oxide film (see Patent Document 3). Such a transparent conductive material has a silicon-doped zinc oxide film, which mitigates variation over time of sheet resistivity under high-temperature and high-moisture conditions. However, crystallinity is degraded, to thereby problematically impair electrical conductivity.

There has also been proposed a transparent heating element having a transparent conductive layer whose heat resistance has been enhanced by adding gallium oxide thereto (see Patent Document 4). However, such a transparent heating element must contain gallium oxide in a limited amount, which problematically limits production conditions.

Heat resistance has been also improved by forming a heat-resistant layer having higher oxidation degree on a transparent conductive layer (see Patent Document 5). Patent Document 5 discloses heat resistance but fails to disclose behavior under high-moisture conditions. That is, there has not been realized control of sheet resistivity under high-temperature and high-moisture conditions.

Alternatively, there has been disclosed enhancement of water-vapor-barrier performance by coating a transparent conductive layer with an overcoat layer predominantly containing polyolefin (see Patent Document 6). In another case, attempts have been made to control sheet resistivity under high-temperature conditions by stacking a heat-resistant electrically conductive layer on a gallium oxide-zinc oxide transparent conductive material.

In a gallium oxide-zinc oxide transparent conductive layer, sheet resistivity under moisture and high temperature conditions has been controlled by considerably increasing the amount of gallium oxide (dopant) and adjusting the thickness to 400 nm (see Non-Patent Document 1). However, when the thickness of the transparent conductive layer is adjusted to 400 nm, productivity is impaired considerably. In addition, when the amount of gallium oxide (dopant) increases greatly, raw material cost increases, which is not practical.

Prior Arts Documents

Patent Documents

Patent Document 1: Japanese Patent Application Laid-Open (kokai) No. 2000-338901

Patent Document 2: Japanese Patent Application Laid-Open (kokai) No. 2007-237588

Patent Document 3: Japanese Patent Application Laid-Open (kokai) No. Hei 8-45452

Patent Document 4: Japanese Patent Application Laid-Open (kokai) No. Hei 6-187833

Patent Document 5: Japanese Patent Application Laid-Open (kokai) No. 2009-199812

Patent Document 6: Japanese Patent Application Laid-Open (kokai) No. 2009-110897

US 5 907 382 A discloses a transparent conductive substrate including a polysilazane layer of around 1 μm thickness and improved water vapour permeability characteristics.

Non-Patent Documents

Non-Patent Document 1: APPLIED PHYSICS LETTERS 89, 091904 (2006)

Summary of the Invention

JP 2010 064303 A discloses a transparent conductive film with the features of the pre-characterising portion of claim 1. Further types of gas barrier films related to the present invention are discussed in S. Iwamori et al., "Characterization of silicon oxynitride gas barrier films", Vacuum, Vol. 68, 2003, pp. 113-117, XP002703709.

Summary of the Invention

Problems to be Solved by the Invention

The present invention has been conceived in order to overcome the aforementioned drawbacks. Thus, an object of the present invention is to provide a transparent conductive film which exhibits excellent gas barrier performance and transparency/electrical conductivity and which exhibits low sheet resistivity and high electrical conductivity, even after having been placed in moist and high-temperature conditions. Another object is to provide a method for producing the transparent conductive film. Still another object is to provide an electronic device employing the transparent conductive film.

Means for Solving the Problems

The present inventors have conducted extensive studies to attain the aforementioned objects and have found that a conductive layer formed from a zinc oxide-based conductive material on the above film. The present invention has been accomplished on the basis of these findings. The inventors have also found that the aforementioned gas barrier layer can be readily and effectively formed through ion implantation into a layer containing a polysilazane compound. The present invention has been accomplished on the basis of these findings.

The present invention is defined in Claim 1. Further advantageous features are set out in the dependent claims.

The present invention enables provision of a transparent conductive film which has excellent transparency and conductivity and which exhibits excellent gas barrier performance and low sheet resistivity, even after having been placed in moist and high-temperature conditions.

According to the production method of the present disclosure, a transparent conductive film which exhibits excellent gas barrier performance can be produced in a simple and safe manner.

The transparent conductive film of the present invention has excellent gas barrier performance and transparent conductivity as well as low sheet resistivity, even after having been placed in moist and high-temperature conditions. Therefore, electronic devices such as displays and solar batteries having such properties can be provided by use of the

transparent conductive film of the present invention.

Brief Description of the Drawings

[FIG. 1] A schematic configuration of a plasma ion implantation apparatus employed in the present invention.
[FIG. 2] A schematic configuration of a plasma ion implantation apparatus employed in the present invention.
[FIG. 3] A schematic cross-sectional view of an embodiment of transparent conductive film of the present invention.
Modes for Carrying Out the Invention

The present invention will next be described in detail in terms of 1) a transparent conductive film, 2) a method for producing a transparent conductive film, and 3) an electronic device.

1) Transparent conductive film

A characteristic feature of the transparent conductive film of the present invention resides in that the transparent conductive film comprises a substrate and, formed on at least one surface of the substrate, a gas barrier layer and a transparent conductive layer, wherein the gas barrier layer is formed of a material containing at least oxygen atoms, nitrogen atoms, and silicon atoms, and includes a surface layer part which has an oxygen atom fraction of 60 to 75%, a nitrogen atom fraction of 0 to 10%, and a silicon atom fraction of 25 to 35%, each atom fraction being calculated with respect to the total number of the oxygen atoms, nitrogen atoms, and silicon atoms contained in the surface layer part and which has a film density of 2.4 to 4.0 g/cm$^3$.

<Gas barrier layer>

The transparent conductive film of the present invention has a gas barrier layer, and the gas barrier layer has the following features:

(a) the gas barrier layer is formed of a material containing at least oxygen atoms and silicon atoms,
(b) the surface layer part has an oxygen atom fraction of 60 to 75% (preferably 63.0 to 70.0%), a nitrogen atom fraction of 0 to 10% (preferably 0.1 to 6.0%), and a silicon atom fraction of 25 to 35% (preferably 29.0 to 32.0%), each atom fraction being calculated with respect to the total number of the oxygen atoms, nitrogen atoms, and silicon atoms contained in the surface layer part, and
(c) the surface layer part has a film density of 2.4 to 4.0 g/cm$^3$.

As described hereinbelow, the gas barrier layer may be a layer which is produced through ion implantation into a layer containing a polysilazane compound.
The term "surface layer part of the gas barrier layer" refers to a region extending from the upper surface of the gas barrier layer to a depth of 5 nm. The surface of the gas barrier layer may be an interface between the gas barrier layer and another layer.
The oxygen atom fraction, nitrogen atom fraction, and silicon atom fraction of the surface layer part are determined through a method described in the Examples hereinbelow.
The film density may be calculated through X-ray reflectivity (XRR).
When an X-ray is introduced to a thin film formed on a substrate at a very small incident angle, the incident X-ray undergoes total reflection. When the incident angle of the X-ray exceeds the total reflection critical angle, the X-ray penetrates the thin film, and the transmission wave and reflection wave are provided at the surface or interface of the thin film. The reflection wave causes interference. Thus, through analysis of the total reflection critical angle, film density can be obtained. Notably, when the measurement is performed with variation of the incident angle, the thickness of the thin film can be determined through analysis of interference signals of the reflection wave associated with the variation in optical path difference.
The total reflection critical angle and film density may be determined and calculated by means of an X-ray reflectivity meter.
The film density may be determined through the following method. More specifically, the film density may be determined through the method described in the Examples.
Generally, the refractive index of a substance n to an X-ray and the real part of the refractive index n ($\delta$) are represented by the following equations 1 and 2:
[E1]

$$n = 1 - \delta - i\beta \quad \cdots \text{Formula 1}$$

[E2]

$$\delta = \left(\frac{r_e \lambda^2}{2\pi}\right) N_0 \rho \sum_i x_i (Z_i + f_i') / \sum_i x_i M_i \quad \cdots \text{Formula 2}$$

(wherein $r_e$ represents the classical electron radius ($2.818 \times 10^{-15}$ m), $N_0$ represents the Avogadro constant, $\lambda$ represents the wavelength of the X-ray, $\rho$ represents a density (g/cm$^3$), $Z_i$ represents the atomic number of atom (i), $M_i$ represents the atomic weight of atom (i), $x_i$ represents the atomic fraction (mole ratio) of atom (i), and $f_i$' represents the atomic scattering factor of atom (i) (i.e., anomalous scattering factor). The total reflection critical angle $\theta c$ is represented by the following equation 3, when the absorption-related factor $\beta$ is ignored.

[E3]

$$\theta c = \sqrt{2\delta} \quad \cdots \text{Formula 3}$$

Accordingly, from equations 2 and 3, the density $\rho$ is derived from equation 4:

[E4]

$$\rho = \frac{\theta c^2 \sum_i x_i M_i}{\left(\frac{r_e \lambda^2}{\pi}\right) N_0 \sum_i x_i (Z_i + f_i')} \quad \cdots \text{Formula 4}$$

(wherein $\theta c$ is a value which may be obtained through X-ray reflectivity, $r_e$, $N_0$, and $\lambda$ are constants, and $Z_i$, $M_i$, and $f_i$' are intrinsic values to the element). Notably, $x_i$ (atomic fraction (mole ratio)) is obtained through XPS.

The film density of the surface layer part of the gas barrier layer may be measured through the method described in the Examples and calculated by equation 4.

The transparent conductive film of the present invention may have a layer which is produced by ion implantation into a layer containing a polysilazane compound (hereinafter may be referred to as a "polysilazane layer") (hereinafter the resultant layer may be referred to as an "ion implantation region"). The layer produced through ion implantation into the polysilazane can serve as a gas barrier layer.

The ion implantation region preferably meets the aforementioned requirements (a) to (c).

The polysilazane employed in the present invention is preferably a compound having a repeating unit represented by the following formula (1). No particular limitation is imposed on the molecular weight of the polysilazane compound employed, but the number average molecular weight is preferably 100 to 50,000.

[F1]

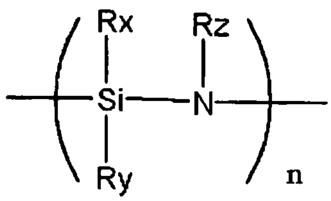

(1)

(wherein n is any natural number)

Rx, Ry, and Rz each represent a non-hydrolyzable group such as a hydrogen atom, a substituted or unsubstituted alkyl group, a substituted or unsubstituted cycloalkyl group, a substituted or unsubstituted alkenyl group, a substituted or unsubstituted aryl group, or an alkylsilyl group.

Examples of the alkyl group in the substituted or unsubstituted alkyl group include C1 to C10 alkyl groups such as methyl, ethyl, n-propyl, isopropyl, n-butyl, isobutyl, sec-butyl, t-butyl, n-pentyl, isopentyl, neopentyl, n-hexyl, n-heptyl, and n-octyl.

Examples of the cycloalkyl group in the substituted or unsubstituted cycloalkyl group include C3 to C10 cycloalkyl groups such as such as cyclobutyl, cyclopentyl, cyclohexyl, and cycloheptyl.

Examples of the alkenyl group in the substituted or unsubstituted alkenyl group include C2 to C10 alkenyl groups such as vinyl, 1-propenyl, 2-propenyl, 1-butenyl, 2-butenyl, and 3-butenyl.

Examples of the substituent of the alkyl group, cycloalkyl group, and alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; and substituted or unsubstituted aryl groups such as a phenyl group, a 4-methylphenyl group, and a 4-chlorophenyl group.

Examples of the aryl group of the substituted or unsubstituted aryl group include C6 to C10 aryl groups such as phenyl, 1-naphthyl, and 2-naphthyl.

Examples of the substituent of the aryl group include halogen atoms such as a fluorine atom, a chlorine atom, a bromine atom, and an iodine atom; C1 to C6 alkyl groups such as methyl and ethyl; C1 to C6 alkoxy groups such as methoxy and ethoxy; a nitro group; a cyano group; a hydroxyl group; a thiol group; an epoxy group; a glycidoxy group; a (meth)acryloyloxy group; and substituted or unsubstituted aryl groups such as a phenyl group, a 4-methylphenyl group, and a 4-chlorophenyl group.

Examples of the alkylsilyl group include trimethylsilyl, triethylsilyl, triisopropylsilyl, tri-t-butylsilyl, methyldiethylsilyl, dimethylsilyl, diethyllsilyl, and methylsilyl, ethylsilyl.

Among them, each of Rx, Ry, and Rz is preferably a hydrogen atom, a C1 to C6 alkyl group, or a phenyl group, with a hydrogen atom being particularly preferred.

The polysilazane employed having a repeating unit represented by the following formula (1) may be either an inorganic polysilazane in which each of the Rx, Ry, and Rz is a hydrogen atom, or an organic polysilazane in which at least one of Rx, Ry, and Rz is not a hydrogen atom. Examples of the inorganic polysilazane include a linear-chain structure perhydropolysilazane having a repeating unit represented by the following formula:

[F2]

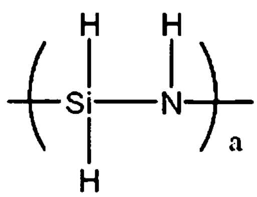

(wherein a represents any natural number), a molecular weight of 690 to 2,000, and 3 to 10 $SiH_3$ groups in a molecule thereof (Japanese Patent Publication (kokoku) No. Sho 63-16325), a linear-chain and branched perhydropolysilazane having a repeating unit represented by formula (A):

[F3]

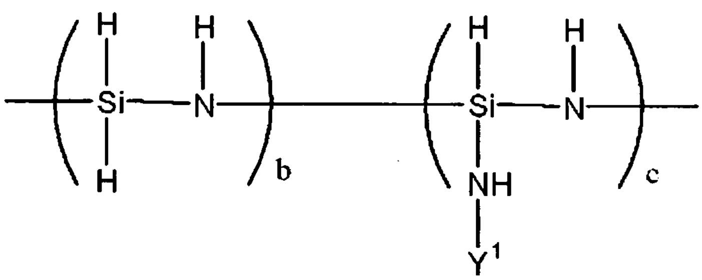

(A)

(wherein each of b and c represents any natural number, and $Y^1$ represents a hydrogen atom or a group represented by formula (B):

[F4]

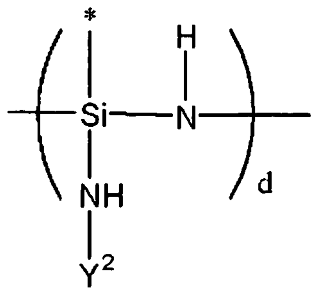

(B)

(wherein d represents any natural number, * represents a bonding site, and $Y^2$ represents a hydrogen atom or a group represented by formula (B)), and a linear-chain, branched, and cyclic perhydropolysilazane having a perhydropolysilazane represented by formula (C).

[F5]

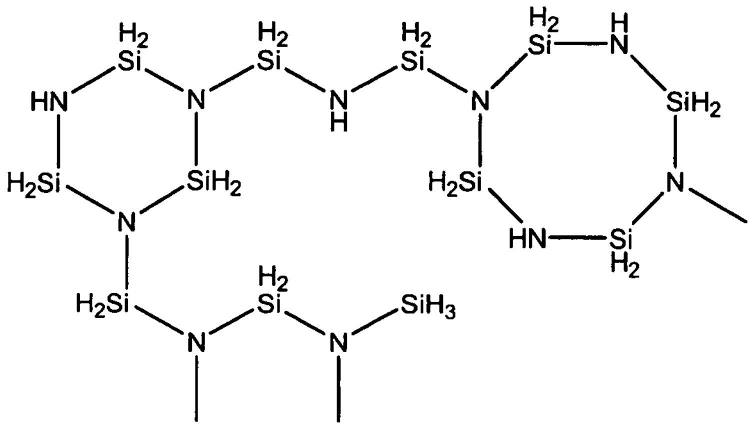

(C)

Examples of the organic polysilazane include the following (i) to (v):

(i) an organic polysilazane having a repeating unit represented by (Rx'SiHNH) (wherein Rx' represents a substituted or unsubstituted alkyl group, a substituted or unsubstituted cycloalkyl group, a substituted or unsubstituted alkenyl group, a substituted or unsubstituted aryl group, or an alkylsilyl group, the same applies to the Rx' hereinbelow) and a cyclic structure (predominant polymerization degree: 3 to 5);
(ii) an organic polysilazane having a repeating unit represented by (Rx'SiHNRz') (wherein Rz' represents a substituted or unsubstituted alkyl group, a substituted or unsubstituted cycloalkyl group, a substituted or unsubstituted alkenyl group, a substituted or unsubstituted aryl group, or an alkylsilyl group) and a cyclic structure (predominant polymerization degree: 3 to 5);
(iii) an organic polysilazane having a repeating unit represented by (Rx'Ry'SiNH) (wherein Ry' represents a substituted or unsubstituted alkyl group, a substituted or unsubstituted cycloalkyl group, a substituted or unsubstituted alkenyl group, a substituted or unsubstituted aryl group, or an alkylsilyl group) and a cyclic structure (predominant polymerization degree: 3 to 5);
(iv) a polyorgano(hydro)silazane having in a molecule thereof a structure represented by the following formula:

[F6]

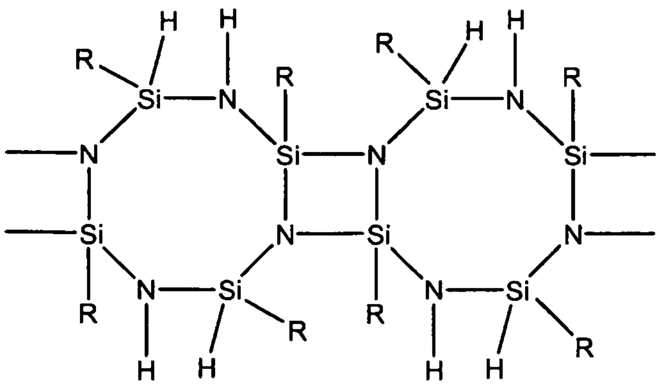

R=$CH_3$

and (v) a polysilazane having a repeating unit represented by the following formula:

[F7]

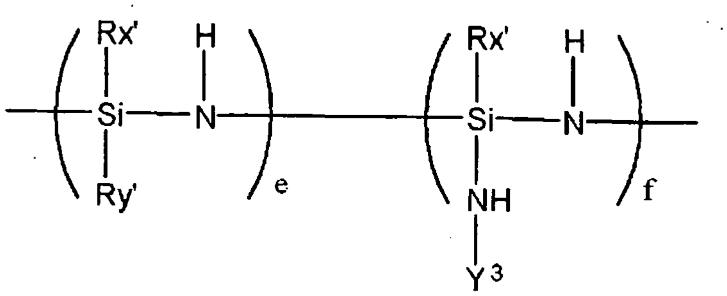

(wherein Rx' and Ry' have the same meanings as defined above, each of e and f represents any natural number, and $Y^3$ represents a hydrogen atom or a group represented by the following formula (E):

[F8]

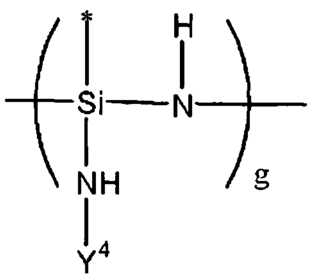

(E)

(wherein g represents any natural number, * represents a bonding site, and $Y^4$ represents a hydrogen atom or a group represented by formula (E)).

The aforementioned organic polysilazane may be produced through a known method. In one production method, an organic polysilazane can be produced through reaction between a secondary amine with a substituted or unsubstituted halogenosilane compound represented by formula (2):

[F9]

$$R^1_{4-m}SiX_m \qquad (2)$$

(wherein m is 2 or 3, X represents a halogen atom, $R^1$ represents a substituent selected from among the aforementioned Rx, Ry, Rz, Rx', Ry', and Rz') and reacting the reaction product with ammonia or a primary amine.

The secondary amine, ammonia, and primary amine may be appropriately chosen in accordance with the structure of the polysilazane compound of interest.

In the present invention, a modified product of polysilazane may be used as a polysilazane compound. Examples of the modified product of polysilazane include a polymetallosylazane containing a metallic atom which may form a cross-linking structure; a polysiloxazane having repeating units represented by $[(SiH_2)_g(NH)_h)]$ and $[SiH_2)_iO]$ (wherein each of g, h, and i is 1, 2, or 3) (Japanese Patent Application Laid-Open (kokai) No. Sho 62-195024); a polyborosilazane produced through reaction of polysilazane with a boron compound (Japanese Patent Application Laid-Open (kokai) No. Hei 2-84437); a polymetallosilazane produced through reaction between polysilazane and metal alkoxide (Japanese Patent Application Laid-Open *(kokai)* No. Sho 63-81122); an inorganic silazane polymer or a modified polysilazane (for example, Japanese Patent Application Laid-Open *(kokai)* No. Hei 1-138108); a silazane copolymr in which an organic component has been incorporated into polysilazane (Japanese Patent Application Laid-Open *(kokai)* No. Hei 2-175726); a low-temperature sintered polysilazane to which a catalyst compound for promoting sintering of polysilazane has been added (for example, Japanese Patent Application Laid-Open *(kokai)* No. Hei 5-238827); a silicon alkoxide-added polysilazane (Japanese Patent Application Laid-Open *(kokai)* No. Hei 5-238827); a glycidol-added polysilazane (Japanese Patent Application Laid-Open *(kokai)* No. Hei 6-122852); an acetylacetonato complex-added polysilazane (Japanese Patent Application Laid-Open *(kokai)* No. Hei 6-306329); a metal carboxylate-added polysilazane (Japanese Patent Application Laid-Open *(kokai)* No. Hei 6-299118); a polysilazane composition containing the aforementioned polysilazane or its modified product and an amine and/or an acid (Japanese Patent Application Laid-Open *(kokai)* No. Hei 9-31333); and modified polysilazanes produced by adding, to a terminal N atom of perhydropolysilazane, an alcohol such as methanol or hexamethyldisilazane (for example, Japanese Patent Application Laid-Open *(kokai)* Nos. Hei 5-345826 and Hei 4-63833).

Among them, an inorganic polysilazane in which each of the Rx, Ry, and Rz is a hydrogen atom, or an organic polysilazane in which at least one of Rx, Ry, and Rz is not a hydrogen atom is preferably used as a polysilazane compound in the present invention, with an inorganic polysilazane being more preferred, from the viewpoints of material availability and successful formation of an ion implantation layer with excellent gas barrier performance.

In the present invention, a commercial product of a glass coating material or the like may be used as a polysilazane compound.

So long as the objects of the present invention are not hampered, the layer containing a polysilazane compound may further contain other ingredients in addition to the polysilazane compound. Examples of such additional ingredients include a curing agent, another polymer, an anti-aging agent, a photostabilizer, and a flame-retardant.

The layer containing a polysilazane compound has a polysilazane compound content of 50 wt.% or more, preferably 70 wt.% or more, since an implantation region having excellent gas barrier performance can be formed.

No particular limitation is imposed on the method for forming the layer containing a polysilazane compound. In one specific method, a layer-forming solution containing at least one polysilazane compound, an optional ingredient, a solvent, etc. is applied onto a film substrate (appropriate base), and the applied coating is appropriately dried.

The application means employed in the invention may be a known apparatus such as a spin-coater, a knife-coater, or a gravure coater.

In order to completely dry the coated film and enhance gas barrier performance, the coated film is preferably heated. Heating is performed at 80 to 150°C for several tens of seconds to several tens of minutes.

Alternatively, the layer containing a polysilazane compound may be formed through bringing a film substrate into contact with a plasma-polymerizable silazane compound gas (e.g., dimethyldisilazane, tetramethyldisilazane, or hexamethyldisilazane) and plasma polymerization (Japanese Patent Application Laid-Open *(kokai)* No. Hei 9-143289).

No particular limitation is imposed on the thickness of the formed layer containing a polysilazane compound, and the thickness is generally 20 nm to 100 μm, preferably 30 to 500 nm, more preferably 40 to 200 nm. In the present invention, even when the layer containing a polysilazane compound has a nanometer-order thickness, a transparent conductive film having sufficient gas barrier performance can be provided.

In the transparent conductive film of the present invention, the gas barrier layer preferably contains at least one species of polysilazane compound. More preferably, the layer has an ion implantation region to which ions have been implanted.

The amount of ions implanted may be appropriately determined in accordance with the purpose of use of the formed product (e.g., required gas barrier performance, transparency, etc.).

Examples of the ion species implanted include ions of a rare gas such as argon, helium, neon, krypton, or

xenon; ions of fluorocarbon, hydrogen, nitrogen, oxygen, carbon dioxide, chlorine, fluorine, sulfur, hydrocarbon, or a silicon compound; ions of electrically conductive metal such as gold, silver, copper, platinum, nickel, palladium, chromium, titanium, molybdenum, niobium, tantalum, tungsten, or aluminum.

Among them, ions of at least one member selected from the group consisting of hydrogen, nitrogen, oxygen, argon, helium, neon, xenon, krypton, a silicon compound, and hydrocarbon is preferred, since these ion species can be implanted in a more simple manner and provides an implantation region having remarkably excellent gas barrier performance and transparency.

No particular limitation is imposed on the ion implantation method. In one specific procedure, a layer containing a polysilazane compound is formed, and then, ions are implanted to the layer containing a polysilazane compound.

Examples of the ion implantation method include irradiating a target layer with ions (ion beam) accelerated by an electric field, and implanting ions in a plasma. Of these, the latter plasma ion implantation is preferably employed in the present invention, since a gas barrier film can be readily formed.

In one specific procedure of plasma ion implantation, a plasma is generated in an atmosphere containing a plasma-generating gas (e.g., rare gas), and a negative high-voltage pulse is applied to a layer containing a polysilazane compound, whereby ions (cations) in the plasma are implanted into the the surface area of the layer containing a polysilazane compound.

The thickness of the portion where the ion implantation region is formed can be controlled by modifying implantation conditions (e.g., type of ionic species, application voltage, and process time). The thickness of the layer containing a polysilazane compound, which may be predetermined in accordance with the purpose of use of the transparent conductive film, is generally 10 to 1,000 nm.

Completion of ion implantation may be confirmed through elemental analysis in an area having a depth of about 10 nm from the surface by X-ray photoelectron spectrometry (XPS).

The transparent conductive film of the present invention comprises a substrate and, formed on at least one surface of the substrate, a gas barrier layer and a transparent conductive layer (described hereinafter) may further include an optional layer. No particular limitation is imposed on the location of the optional layer, and the optional layer may be a single layer or a multiple layer. One example of the optional layer is a substrate formed of a material other than a polysilazane compound. Another example of the optional layer is a hard coating layer which shields oligomeric ingredients and low-molecular-weight ingredients contained in the substrate. No particular limitation is imposed on the material of the hard coating layer, and known materials such as energy-beam-curable resin and heat-curable resin may be employed. The hard coating layer preferably has a thickness of 0.1 to 20 μm, particularly preferably 1 to 10 μm.

<Substrate>

No particular limitation is imposed on the transparent conductive film of the present invention, so long as it is suited for a transparent conductive film. Examples of the material include polyimde, polyamide, polyamide-imide, polyphenylene ether, polyether ketone, polyether ether ketone, polyolefin, polyester, polycarbonate, polysulfone, polyether sulfone, polyphenyl sulfone, modified polysulfone, polyphenylene sulfide, polyarylate, acrylic resin, cycloolfin polymer, aromatic polymer, polyurethane, and film produced from thermally curable or radiation-curable resin by heat or radiation. In addition to the material, the film may further contain various additives such as an anti-oxidant, a flame-retardant, a high-refractive index material, a low-refractive index material, and a lubricant, so long as gas barrier performance, transparency, and electrical conductivity are not impaired.

Among the above materials, polyester, polyamide, and cycloolefin polymer are preferred, with polyester and cycloolefin polymer being more preferred, since these material have excellent transparency and general usability.

Examples of the polyester include polyethylene terephthalate, polybutylene terephthalate, polyethylene naphthalate, and polyarylate.

Examples of the polyamide include wholly aromatic polyamides, nylon 6, nylon 66, and nylon copolymer.

Examples of the cycloolefin polymer include norbornene polymer, monocyclic olefin polymer, cyclic conjugated diene polymer, vinyl alicyclic hydrocarbon polymer, and hydrogenated products thereof. Specific examples include Apel (ethylene-cycloolefin copolymer, product of Mitsui Chemicals Inc.), Arton (norbornene polymer, product of JSR), and Zronoa (norbornene polymer, product of Nippon Zeon Co., Ltd.). The substrate preferably has a thickness of 0.01 to 0.5 mm, more preferably 0.05 to 0.25 mm. When the thickness falls within the range, suitable transparency and flexibility can be attained, and the film product can be easily handled.

In the case where the transparent conductive film of the present invention is a stacked structure including an optional layer, no particular limitation is imposed on the location of the gas barrier layer. However, for facilitate the production of the transparent conductive film, the stacked structure preferably has a configuration in which a transparent conductive layer is in direct contact with the ion implantation region. The gas barrier layer of the transparent conductive film of the present invention may be formed on one surface of the optional layer or both surfaces of the optional layer.

<Transparent conductive layer>

A characteristic feature of the transparent conductive film of the present invention resides in that the film has a structure in which a transparent conductive layer is stacked on a gas barrier layer. Through provision of the transparent conductive layer, the film can serve as an electrode and is suitably employed in devices such as an organic EL display. No particular limitation is imposed on the composition of the transparent conductive layer, and the layer may be formed from any material. Examples of the material include metals such as platinum, gold, silver and copper; carbon materials such as graphene and carbon nanotube; organic conductive materials such as polyaniline, polyacetylene, polythiophene, poly(p-phenylene-vinylene), and polyethylene-dioxythiophene; tin oxide, indium oxide, and cadmium oxide; complex oxides such as tin-doped indium oxide (ITO), and tin- and gallium-doped indium oxide (IGZO); non-oxide compounds such as chalcogenide, lanthanum hexaboride, titanium nitride, and titanium carbide; oxides such as zinc oxide and zinc dioxide; and zinc oxide-based conductive materials such as zinc oxide-doped indium oxide, fluorine-doped indium oxide, antimony-doped tin oxide, fluorine-doped tin oxide, aluminum-doped zinc oxide, and gallium-doped zinc oxide.

The zinc oxide-based conductive material predominantly contains zinc oxide, and preferably in an amount of 90 mass% or more. However, the other composition of the zinc oxide-based conductive layer is not limited, and the material may further contain an additive element or an additive for lowering resistivity. Examples of such an additive include aluminum, indium, boron, gallium, silicon, tin, germanium, antimony, iridium, rhenium, cerium, zirconium, scandium, and yttrium. The layer may contain at least one member of the additive elements and additives, and the total amount of such additives is preferably 0.05 to 10 mass%.

The organic conductive material may further contain a dopant such as iodine, arsenic pentafluoride, alkali metal, or polyanion poly(styrenesulfonate salt). A specific example thereof is polyethylene-dioxythiophene (CLEVIOS P AI 4083, product of H.C. Starck).

In the present invention, the transparent conductive layer is preferably formed from a zinc oxide-based conductive material such as tin-doped indium oxide (ITO), zinc oxide, or zinc oxide-doped indium oxide (IZO, registered trademark), or fluorine-containing tin oxide (FTO).

The transparent conductive layer may be formed through a known method such as sputtering, ion plating, vacuum vapor deposition, or chemical vapor deposition, or through a coating method such as bar-coater coating or microgravure coating. Before film formation of transparent conductive material, a film having a gas barrier performance may be heated in vacuum or under atmospheric pressure at a temperature not higher than the melting temperature of the film, or may be subjected to plasma treatment or irradiation with a UV beam.

The thickness of the transparent conductive layer, which varies depending on the use thereof, is, for example, 10 nm to 5 μm, preferably 20 nm to 1,000 nm, more preferably 20 nm to 500 nm.

The transparent conductive film of the present invention has excellent gas barrier performance, transparency, and conductivity. When the film is a film-like or sheet-like (hereinafter referred to as film-like), preferably, the film has excellent flexibility and maintains gas barrier performance even after bending.

The excellent gas barrier performance of the transparent conductive film of the present invention can be confirmed by that a gas (e.g., water vapor) permeability of the transparent conductive film of the present invention is small. Specifically, the water vapor permeability (in a 40°C-90% RH atmosphere) is preferably less than 0.50 g/m$^2$/day or less, more preferably 0.35 g/m$^2$/day or less. The gas (e.g., water vapor) permeability of the transparent conductive film may be measured by means of a known gas permeability measuring apparatus.

The transparent conductive film of the present invention preferably has a sheet resistivity of 1,000 Ω/square or less, more preferably 500 Ω/square or less, yet more preferably 100 Ω/square or less. The sheet resistivity of the transparent conductive film may be measured by means of a known method.

The transparent conductive film of the present invention preferably exhibits a change ratio in sheet resistivity represented by $T_1=(R_1-R_0)/R_0$ of 1.0 or less (more preferably 0.5 or less, still more preferably 0.1 or less), and a change ratio in sheet resistivity represented by $T_2=(R_2-R_0)/R_0$ of 1.0 or less (more preferably 0.2 or less), wherein $R_0$ represents an initial sheet resistivity, $R_1$ represents a sheet resistivity after the film has been placed under a 60°C condition for seven days, and $R_2$ represents a sheet resistivity after the film has been placed under a 60°C-90% RH condition for seven days.

The excellent transparency of the transparent conductive film of the present invention can be confirmed from the fact that the transparent conductive film of the present invention has high visible-light transmittance. The visible-light transmittance at a wavelength of 550 nm is preferably 70% or higher, more preferably 75% or higher. The visible-light transmittance of the transparent conductive film may be measured by means of a known visible-light transmittance meter.

No particular limitation is imposed on the thickness of the transparent conductive film of the present invention. When the film is employed as an electronic device member, the thickness is preferably about 1 to about 1,000 μm.

2) Method for producing transparent conductive film

A characteristic feature of the method for producing a transparent conductive film resides in that the method comprises a step of performing ion implantation into a surface layer part of a layer containing a polysilazane compound, which layer is included in a film having on a surface portion thereof the layer containing a polysilazane compound, and a step of forming, on the ion implantation region, a transparent conductive layer.

In the method for producing a transparent conductive film, preferably, ions are implanted to a layer containing a polysilazene compound included in a film, while the elongated film having a layer containing a polysilazane compound is conveyed in a specific direction.

The film having a layer containing a polysilazane compound is a film formed of a substrate on which a layer containing a polysilazane compound is provided.

Through the above production method, the following procedure can be realized. Specifically, an elongated film is unwound from a unwinding roller, and ions are implanted to the film while the film is conveyed in a specific direction. The thus-process film is wound by means of a winding roller. Thus, ion-implanted film can be continuously produced.

The elongated film which includes a layer containing polysilazane compound may be a single layer containing a polysilazane compound or a multi-layer film including an additional layer. Examples of the additional layer which may be employed in the invention are the same as described above.

The thickness of the elongated film having a layer containing a polysilazane compound is preferably 1 $\mu$m to 500 $\mu$m, more preferably 5 $\mu$m to 300 $\mu$m, from the viewpoint of operability in unwinding, winding, and conveying.

No particular limitation is imposed on the ion implantation into the layer containing a polysilazane compound. Among various methods, plasma ion implantation is particularly preferably employed so as to form an ion implantation region in the surface layer part of the layer.

In the plasma ion implantation method, a negative high-voltage pulse is applied to a layer containing a polysilazane compound exposed to plasma, whereby ions in the plasma are implanted to the surface layer part of the layer, to thereby form an ion implantation region.

A preferred mode of plasma ion implantation (A) includes implanting ions present in a plasma generated by an external electric field to the surface layer part of the layer. Another preferred mode of plasma ion implantation (B) includes implanting ions present in a plasma generated only by the negative high-voltage pulse applied to the layer (not employing an external electric field) to the surface layer part of the layer.

In the mode (A), the pressure at ion implantation (i.e., the pressure at plasma ion implantation) is preferably adjusted to 0.01 to 1 Pa. When the plasma ion implantation pressure falls within the range, a uniform implantation region can be formed easily and effectively, whereby an ion implantation region having transparency and gas barrier performance can be effectively formed.

In the mode (B), high vacuum degree is not needed, and the operation can be easily carried out, whereby the processing time can be remarkably shortened. Also, the entirety of the layer can be uniformly treated, and high-energy ions in the plasma can be continuously implanted to the surface layer part of the layer during application of negative high-voltage pulse. Furthermore, a uniform, high-quality ion implantation region can be formed in the surface layer part of the layer merely through application of negative high-voltage pulse, without employing a special means such as high-frequency (e.g., radio frequency (high frequency, hereinafter abbreviated as "RF") or microwave) power source.

In either of mode (A) or (B), the pulse width of the negative high-voltage pulse at the time of pulse application (i.e., ion implantation) is preferably 1 to 15 $\mu$sec. When the pulse width falls within the range, a transparent and uniform ion implantation region can be formed easily and effectively.

The application voltage for generating plasma is preferably -1 kV to -50 kV, more preferably -1 kV to -30 kV, particularly preferably -5 kV to -20 kV. When the application voltage during ion implantation is higher than -1 kV, ion implantation (dose) is insufficient, to thereby fail to attain performance of interest, whereas when the voltage is lower than -50 kV, the film is electrically charged during ion implantation, causing undesired coloring or the like, which is not preferred.

Examples of the ion species implanted through plasma ion implantation include ions of a rare gas such as argon, helium, neon, krypton, or xenon; ions of fluorocarbon, hydrogen, nitrogen, oxygen, carbon dioxide, chlorine, fluorine, sulfur, hydrocarbon, a silicon compound; ions of electrically conductive metal such as gold, silver, copper, platinum, nickel, palladium, chromium, titanium, molybdenum, niobium, tantalum, tungsten, or aluminum. Among them, hydrogen, nitrogen, oxygen, argon, helium, neon, xenon, and krypton are preferred, with ions of nitrogen, oxygen, argon, or helium being more preferred, since these ion species can be implanted in a simple manner and a film having remarkably excellent gas barrier performance and transparency can be effectively produced.

For ion implantation of ions present in the plasma to the surface layer part of the layer, a plasma ion implantation apparatus is employed. Specific examples of the plasma ion implantation apparatus include the following:

($\alpha$) a plasma ion implantation apparatus in which high-frequency power is superimposed on a feed-through for

applying negative high-voltage pulse to a layer containing a polysilazane compound (hereinafter may be referred to as an "ion implantation target layer"), wherein the ion implantation target layer is surrounded by the plasma, and induction, implantation, collision, and deposition of ions in the plasma are performed (Japanese Patent Application Laid-Open *(kokai)* No. 2001-26887),

(β) a plasma ion implantation apparatus having an antenna in a chamber in which a plasma is generated by high-frequency power, and after the plasma has reached the surround of the ion implantation target layer, positive pulse and negative pulse are alternatingly applied to the ion implantation target layer, whereby electrons in the plasma are inducted and caused to collide by the positive pulse, to thereby heat the ion implantation target layer, and ions in the plasma are induced and implanted through application of the negative pulse while the pulse constant is controlled for controlling temperature (Japanese Patent Application laid-Open *(kokai)* No. 2001-156013),

(γ) a plasma ion implantation apparatus in which a plasma is generated by means of only an external electric field such as a high-frequency (e.g., microwave) power source, and ions in the plasma are induced and implanted through application of high-voltage pulse, and

(δ) a plasma ion implantation apparatus in which a plasma is generated by means of an electric field generated through application of high-voltage pulse without employing an external electric field, and ions in the plasma are implanted.

Among these plasma ion implantation apparatuses, the plasma ion implantation apparatus (γ) or (δ) is preferably employed, by virtue of simple operability, very shortened processing time, and suitability to continuous operation.

Hereinafter, an ion implantation technique employing the aforementioned plasma ion implantation apparatuses (γ) or (δ) will be described in detail with reference to the drawings.

FIG. 1 is a schematic representation of a continuous plasma ion implantation apparatus employing the plasma ion implantation apparatus (γ) above.

In FIG. 1(a), 1a denotes an elongated film including a layer containing a polysilazane compound (hereinafter may be referred to as a "film"), 11a a chamber, 20a a turbo molecular pump, 3a an unwinding roller for feeding the film 1a before ion implantation, 5a a winding roller for winding the film 1a which has undergone ion implantation, to thereby provide a rolled film, 2a a high-voltage application rotatable can, 6a a feed roller, 10a a gas inlet, 7a a high-voltage pulse power source, and 4 a plasma discharge electrode (external electric field). FIG. 1(b) is a perspective view of the aforementioned high-voltage application rotatable can 2a. The numeral 15 denotes a high-voltage-introduction terminal (feed-through).

The elongated film 1a including, in a surface portion thereof, a layer containing a polysilazane compound employed in this embodiment is a film comprising a layer containing a polysilazane compound formed on a substrate (or an optional layer).

In the continuous plasma ion implantation apparatus shown in FIG. 1, the film 1a is conveyed from the unwinding roller 3a in the direction denoted by arrow X (FIG. 1) in the chamber 11a, passes around the high-voltage application rotatable can 2a, and is wound by the winding roller 5a. No particular limitation is imposed on the method of winding or conveying the film 1a. In the present embodiment, the film 1a is conveyed by rotating the high-voltage application rotatable can 2a at a constant rotating speed. The rotation of the high-voltage application rotatable can 2a is performed through rotating the center axis 13 of the high-voltage-introduction terminal 15 by means of a motor.

Members such as the high-voltage-introduction terminal 15 and a plurality of feed rollers 6a which come into contact with the film 1a are formed of an insulator (e.g., alumina coated with a resin such as polytetrafluoroethylene). The high-voltage application rotatable can 2a may be formed of a conductor (e.g., stainless steel).

The film 1a conveying speed may be appropriately predetermined. No particular limitation is imposed on the conveying speed, so long as ions are implanted to the surface layer part of the film 1a (a layer containing a polysilazane compound) while the film 1a is conveyed from the unwinding roller 3a and is wound by the winding roller 5a, and a sufficient period of time required for forming an ion implantation region is ensured. The film winding speed (i.e., conveying speed), which varies depending on factors such as applied voltage and apparatus scale, is generally 0.1 to 3 m/min, preferably 0.2 to 2.5 m/min.

Firstly, the chamber 11a is evacuated by means of the turbo molecular pump 20a connected to the rotary pump. The degree of vacuum is generally $1 \times 10^{-4}$ Pa to 1 Pa, preferably $1 \times 10^{-3}$ Pa to $1 \times 10^{-2}$ Pa.

Then, a gas (e.g., nitrogen) for ion implantation (hereinafter may be referred to as an "ion implantation gas") is fed into the chamber 11a via the gas inlet 10a, to thereby attain a reduced-pressure ion implantation gas atmosphere in the chamber 11a. Notably, the ion implantation gas also serves as a plasma generating gas.

Subsequently, a plasma is generated by means of the plasma discharge electrode 4 (external electric field). The plasma generation is performed through known means,(e.g., microwave or RF high-frequency power source).

Separately, negative high-voltage pulse 9a is applied by means of the high-voltage pulse power source 7a, which is connected to the high-voltage application rotatable can 2a via the high-voltage-introduction terminal 15. Through application of negative high-voltage pulse to the high-voltage application rotatable can 2a, ions are induced in the plasma,

and the ions are implanted to the surface of the film surrounding the high-voltage application rotatable can 2a (FIG. 1(a), arrow Y), to thereby form a film 1b.

As described above, the pressure at ion implantation (plasma gas pressure in the chamber 11a) is preferably 0.01 to 1 Pa. The pulse width at ion implantation is preferably 1 to 15 μsec. The voltage applied to the high-voltage application rotatable can 2a is preferably -1 kV to -50 kV.

Next will be described a procedure of ion implantation into a layer containing a polysilazane compound, the layer included in the film including, in the surface layer part thereof, the layer containing a polysilazane compound, by means of a continuous plasma ion implantation apparatus as shown in FIG 2.

The apparatus shown in FIG. 2 includes the aforementioned plasma ion implantation apparatus (δ). The plasma ion implantation apparatus is adapted to generate plasma only by an electric field generated by high-voltage pulse without employing an external electric field (i.e., the plasma discharge electrode 4 shown in FIG. 1).

In the continuous plasma ion implantation apparatus shown in FIG. 2, in a manner similar to that employed in the apparatus shown in FIG. 1, a film (film-shape formed product) 1c is conveyed from the unwinding roller 3b in the direction denoted by arrow X in FIG. 2, through rotation of the high-voltage application rotatable can 2b, and is wound by the winding roller 5b.

In the continuous plasma ion implantation apparatus shown in FIG. 2, ions are implanted to the surface layer part of the layer containing a polysilazane compound included in the film through the following procedure.

Firstly, similar to the plasma ion implantation apparatus shown in FIG. 1, a film 1c is placed in a chamber 11b, and the chamber 11b is evacuated by means of the turbo molecular pump 20b connected to the rotary pump. Then, an ion implantation gas (e.g., nitrogen) is fed into the chamber 11b via the gas inlet 10b, to thereby attain a reduced-pressure ion implantation gas atmosphere in the chamber 11b.

The pressure at ion implantation (plasma gas pressure in the chamber 11b) is 10 Pa or less, preferably 0.01 to 5 Pa, more preferably 0.01 to 1 Pa.

Then, a high-voltage pulse 9b is applied, via a high-voltage-introduction terminal (not illustrated), to the film 1c by means of a high-voltage pulse power source 7b connected to the high-voltage application rotatable can 2b, while the film 1c is conveyed in the direction X shown in FIG. 2.

Through application of negative high-voltage to the high-voltage application rotatable can 2b, a plasma is generated along the film 1c surrounding the high-voltage application rotatable can 2b. Thus, ions are induced in the plasma, and the ions are implanted to the surface of the film 1c surrounding the high-voltage application rotatable can 2b (FIG. 2, arrow Y). When ions are implanted to the surface layer part of the layer containing a polysilazane compound included in the film 1c, an ion implantation region is formed in the surface layer part of the film, to thereby form a film 1d.

The voltage applied to the high-voltage application rotatable can 2b, the pulse width, and the pressure at ion implantation are the same as those employed in the continuous plasma ion implantation apparatus shown in FIG. 1.

In the plasma ion implantation apparatus shown in FIG. 2, the high-voltage pulse power source serves as plasma generation means. Therefore, without employing any particular means such as a high-frequency (e.g., microwave or RF) power source, a plasma can be generated only through application of a negative high-voltage pulse, and ions in the plasma can be implanted to the surface layer part of the layer containing a polysilazane compound included in the film. As a result, such an ion implantation region can be continuously formed, whereby film having a gas barrier layer in which an ion implantation region is formed in the surface layer part thereof can be mass-produced.

On the thus-produced gas barrier layer, a transparent conductive layer is formed. The transparent conductive layer may be formed from a metal oxide through a conventionally known method. The zinc oxide-based transparent conductive layer, which exhibits problematic variation in sheet resistance under moist and high-temperature conditions, will next be described in detail. The zinc oxide-based transparent conductive material may further contain an additive for lowering resistivity. Examples of such an additive include aluminum, indium, boron, gallium, silicon, tin, germanium, antimony, iridium, rhenium, cerium, zirconium, scandium, and yttrium. The layer may contain at least one member of the additive elements and additives, and the total amount of such additives is preferably 0.05 to 15 mass%. The zinc oxide-based transparent conductive material may be formed through a known film formation method such as sputtering, ion plating, vacuum vapor deposition, or chemical vapor deposition. Before film formation of transparent conductive material, a film having a gas barrier performance may be heated in vacuum or air at a temperature not higher than the melting temperature of the film, or may be subjected to plasma treatment or irradiation with a UV beam.

FIG. 3 is a schematic cross-section of a typical structure of the transparent conductive film of the present invention. As shown in FIG. 3, a transparent conductive film 100 has a film-shape substrate 110, a gas barrier layer 120, a transparent conductive layer 130 formed of a zinc oxide-based conductive material. The gas barrier layer 120 is formed of a layer containing a polysilazane compound. The surface layer part of the gas barrier layer 120 includes an ion implantation region 121 formed through ion implantation. The transparent conductive layer 130 is provided on the gas barrier layer 120.

The transparent conductive film 100 may further include a layer formed of another material. In the above structure, the transparent conductive layer 130 is directly formed on the gas barrier layer 120. However, an optional

layer formed of another material may intervene between the two layers. Alternatively, an optional layer formed of another material may intervene between the film-shape substrate 110 and the gas barrier layer 120. Still alternatively, such an optional layer may intervene both spaces. Yet alternatively, an optional layer formed of another material may be formed on the surface of the film-shape substrate 110 opposite the surface on which the gas barrier layer 120 is formed. An optional layer formed of another material may be formed on the surface of the transparent conductive layer 130 opposite the surface on which the gas barrier layer 120 is formed.

The layer configuration of the transparent conductive film of the present invention is not limited to the aforementioned configuration, so long as the transparent conductive film includes a substrate, a gas barrier layer, and a transparent conductive layer. These layers may be stacked in any order, and each component layer may be stacked multiply.

3) Electronic device

The transparent conductive film of the present invention exhibits excellent gas barrier performance and transparent electrical conductivity. Thus, when the transparent conductive film is used in an electronic device, deterioration of an element thereof which would otherwise be caused by gas (e.g., water vapor) can be prevented. Also, by virtue of high optical transparency, the transparent conductive film of the invention is suitably employed as a display member such as a touch panel, a liquid crystal display, or an EL display; a transparent electrode for use in a solar battery; an electrode for an organic transistor, etc.

The electronic device of the present invention has the transparent conductive film of the present invention. Examples of the electronic device include a liquid crystal display, an organic EL display, an inorganic EL display, an electronic paper, a solar battery, and an organic transistor.

The electronic device of the present invention, which has the transparent conductive film of the present invention, exhibits excellent gas barrier performance and transparent electrical conductivity.

Examples

The present invention will next be described in more detail by way of examples, which should not be construed as limiting the present invention thereto.

The following X-ray photoelectron spectrometer, layer thickness determination method based on the X-ray reflectivity method, plasma ion implantation apparatus, water vapor permeability measurement apparatus (with measurement conditions), and visible-light transmittance measurement apparatus were employed. Notably, the plasma ion implantation apparatus performs ion implantation through employment of an external electric field.

(X-ray photoelectron spectrometer)

Under the following measurement conditions, the oxygen atom fraction, nitrogen atom fraction, and silicon atom fraction of the surface layer part of the gas barrier layer were determined.
Spectrometer: PHI Quantera SXM, product of ULVAC Phi Inc.
X-ray beam diameter: 100 μm
Power: 25 W
Voltage: 15 kV
Take-off angle: 45°

(Determination of film density by X-ray reflectivity method)

The film density of the surface layer part of the gas barrier layer was determined by measuring the X-ray reflectivity under the following measurement conditions, to thereby obtain the total reflection critical angle $\theta c$, and calculating the film density from the total reflection critical angle.

The measurement was performed by means of the following apparatus under the following conditions.
Measurement apparatus: Sample mounted horizontally X-ray diffractometer for thin film evaluation "SmartLab," product of Rigaku Corporation
Measurement conditions:

X-ray source; Cu-K$\alpha$1 (wavelength: 1.54059Å)
Optical system; parallel beam optical system
Incident slit system; Ge(220)2 crystal, height-limiting slit 5 mm, incident slit 0.05 mm
Photoreceptor slit system; photoreceptor slit 0.10 mm, solar slit 5°

Detector; scintillation counter
Tube voltage/current; 45 kV-200 mA
Scan axis; 2θ/θ
Scan mode; continuous scanning
Scan range; 0.1 to 3.0 degrees
Scan rate; 1 degree/min
Sampling pitch; 0.002°/step

The atomic fraction (xi) was each atom (oxygen, nitrogen, or silicon) fraction of the surface layer part of the gas barrier layer obtained through X-ray photoelectron spectrometry.

The following A and B were used as polysilazane compounds.

A: coating agent predominantly containing perhydropolysilazane (Aquamica NL110-20, product of Clariant Japan K.K.)
B: coating material predominantly containing a mixture of organopolysilazane compounds having a saturated hydrocarbon group (tutoProm Bright, product of Clariant Japan K.K.)

(Plasma ion implantation apparatus)

RF power source: Model RF56000, product of JEOL Ltd. High-voltage pulse power source: PV-3-HSHV-0835, product of Kurita Seisakusyo Co., Ltd.

(Measurement of water vapor permeability)

Water vapor permeability measurement apparatus: "L89-500," product of LYSSY (water vapor permeability of 0.01 $g/m^2/day$ or higher) and "deltaperm," product of TECHNOLOX (water vapor permeability less than 0.01 $g/m^2/day$ or lower)
Measurement conditions: RH 90%, 40°C

(Measurement of visible-light transmittance)

Visible-light transmittance measurement apparatus: UV-3101PC, product of Shimadzu Corporation
Measurement condition: wavelength 550 nm

(Sheet resistivity)

The sheet resistivity of each transparent conductive film (surface resistivity of transparent conductive layer) in a 23°C-50% RH atmosphere was measured by means of LORESTA-GP MCP-T600 (product of Mitsubishi Chemical Co., Ltd.), with PROBE TYPE LSP (product of Mitsubishi Chemical Analytech Co., Ltd.) as a probe.

(Moisture- and heat-resistance test)

A transparent conductive film test piece was placed for seven days in a 60°C atmosphere or a 60°C-90% RH atmosphere. After removal from each atmosphere, the test piece was reconditioned for one day in a 23°C-50% RH (i.e., relative humidity) atmosphere, and the sheet resistivity thereof was measured. From the sheet resistivity $R_0$ (before test), the sheet resistivity $R_1$ (after placement in a 60°C atmosphere for 7 days), and the sheet resistivity $R_2$ (after placement in a 60°C-90% RH atmosphere for 7 days), $T_1$ and $T_2$ (evaluation parameters) were calculated by the following equations:

$$T_1 = (R_1 - R_0)/R_0$$

$$T_2 = (R_2 - R_0)/R_0 .$$

Example 1

Polyethylene terephthalate film (PET188 A-4300, product of Toyobo, thickness: 188 μm) (hereinafter referred

to as PET film) was employed as a substrate. A polysilazane compound (A) was applied onto the substrate and heated at 120°C for one minute, to thereby form a layer containing perhydropolysilazane and having a thickness of 60 nm (film thickness) on the PET film. Subsequently, argon (Ar) ions were implanted through plasma ion implantation into the surface of the layer containing perhydropolysilazane by means of the plasma ion implantation apparatus shown in FIG. 1, to thereby form a gas barrier layer.

Plasma ion implantation was performed under the following conditions.

- Plasma-generating gas : Ar
- Gas flow rate: 100 sccm
- Duty ratio: 0.5%
- Repetition frequency: 1,000 Hz
- Applied voltage: -10 kV
- RF power source: frequency 13.56 MHz, applied power 1,000 W
- Chamber pressure: 0.2 Pa
- Pulse width: 5 μsec
- Process time (ion implantation time): 5 min
- Conveying speed: 0.2 m/min

A layer of a transparent conductive layer of zinc oxide-based conductive material was formed on the surface of the thus-formed gas barrier layer through DC magnetron sputtering by use of a zinc oxide target containing 5.7 mass% $Ga_2O_3$ (product of Sumitomo Metal Mining Co., Ltd.) to a film thickness of 100 nm, whereby a target transparent conductive film 1 of Example 1 was produced.

The transparent conductive layer was formed from gallium-added zinc oxide under the following conditions.

- Substrate temperature: room temperature
- DC output: 500 W
- Carrier gas: argon
- Vacuum degree: 0.3 to 0.8 Pa

Example 2

The procedure of Example 1 was repeated, except that the heating time was change from 1 minute to 5 minutes, to thereby form a transparent conductive film of Example 2.

Example 3

The procedure of Example 2 was repeated, except that the thickness of the layer containing perhydropolysilazane formed on the PET film was change from 60 nm to 100 nm, to thereby form a transparent conductive film of Example 3.

Example 4

The procedure of Example 2 was repeated, except that the thickness of the layer containing perhydropolysilazane formed on the PET film was change from 60 nm to 150 nm, to thereby form a transparent conductive film of Example 4.

Example 5

The procedure of Example 1 was repeated, except that the heating time was change from 1 minute to 20 minutes, to thereby form a transparent conductive film of Example 5.

Example 6

The procedure of Example 2 was repeated, except that nitrogen ($N_2$) was used instead of argon as a plasma-generating gas, to thereby form a transparent conductive film of Example 6.

Example 7

The procedure of Example 2 was repeated, except that the application voltage at ion implantation was changed from -10 kV to -5 kV, to thereby form a transparent conductive film of Example 7.

Example 8

The procedure of Example 2 was repeated, except that the application voltage at ion implantation was changed from -10 kV to -15 kV, to thereby form a transparent conductive film of Example 8.

Example 9

The procedure of Example 2 was repeated, except that polysilazane compound B was used instead of polysilazane compound A, to thereby form a transparent conductive film of Example 9.

Example 10

The procedure of Example 2 was repeated, except that hydrogen ($H_2$) was used instead of argon as a plasma-generating gas, to thereby form a transparent conductive film of Example 10.

Example 11

The procedure of Example 2 was repeated, except that oxygen ($O_2$) was used instead of argon as a plasma-generating gas, to thereby form a transparent conductive film of Example 11.

Example 12

The procedure of Example 2 was repeated, except that helium (He) was used instead of argon as a plasma-generating gas, to thereby form a transparent conductive film of Example 12.

Example 13

The procedure of Example 2 was repeated, except that neon (Ne) was used instead of argon as a plasma-generating gas, to thereby form a transparent conductive film of Example 13.

Example 14

The procedure of Example 2 was repeated, except that xenon (Xe) was used instead of argon as a plasma-generating gas, to thereby form a transparent conductive film of Example 14.

Example 15

The procedure of Example 2 was repeated, except that krypton (Kr) was used instead of argon as a plasma-generating gas, to thereby form a transparent conductive film of Example 15.

Example 16

The procedure of Example 1 was repeated, except that polyethylene naphthalate (product of Teijin DuPont, thickness: 200 μm, trade name: Q65FA) (hereinafter referred to as PEN film) was employed as a substrate instead of the PET film employed in Example 1, that polysilazane compound A was applied onto an easy-adhesion surface of the substrate, and that argon ions were implanted to the formed coating layer, to thereby form a transparent conductive film of Example 16.

Example 17

Polysulfone (Ultrazone S3010, product of BASF Japan) was extruded, to thereby form a polysulfone film having a thickness of 100 μm. The procedure of Example 1 was repeated, except that the thus-produced polysulfone film was used as a substrate instead of the PET film employed in Example 1, to thereby form a transparent conductive film of Example 17.

Example 18

Polycarbonate (Tuflon LC2200, product of Idemitsu Kosan CO., Ltd.) was extruded, to thereby form a polycarbonate film having a thickness of 100 μm. The procedure of Example 1 was repeated, except that the thus-produced polycarbonate film was used as a substrate instead of the PET film employed in Example 1, to thereby form a transparent conductive film of Example 18.

Example 19

Polyarylate (P-1001, product of Unitika Ltd.) was extruded, to thereby form a polyarylate film having a thickness of 100 μm. The procedure of Example 1 was repeated, except that the thus-produced polyarylate film was used as a substrate instead of the PET film employed in Example 1, to thereby form a transparent conductive film of Example 19.

Example 20

The procedure of Example 1 was repeated, except that an alicyclic hydrocarbon resin film (Zeonor ZF16, thickness: 100 μm, product of Zeon Kasei Co.) was employed as a substrate instead of the PET film employed in Example 1, to thereby form a transparent conductive film of Example 20.

Comparative Example 1

The procedure of Example 1 was repeated, except that ion implantation was not performed, to thereby form a transparent conductive film of Comparative Example 1. Specifically, a layer containing perhydropolysilazane was formed on the PET film, and a transparent conductive layer was formed on the layer, to thereby form a transparent conductive film of Comparative Example 1.

Comparative Example 2

The procedure of Example 1 was repeated, except that a layer containing perhydropolysilazane was not formed on the PET film, to thereby form a transparent conductive film of Comparative Example 2. Specifically, argon ions were implanted to the surface of the PET film through plasma ion implantation, to thereby form a transparent conductive film of Comparative Example 2.

Comparative Example 3

The layer containing perhydropolysilazane included in the formed product of Example 2 was subjected to plasma treatment by use of argon (Ar) as a plasma-generating gas. Then, a transparent conductive layer was formed on the plasma-treated surface, to thereby produce a transparent conductive film of Comparative Example 3. The plasma treatment was performed in a state where plasma ion implantation was inhibited by controlling the application voltage of the apparatus employed in the Examples to 0 kV.
Plasma treatment was performed under the following conditions.

- Plasma-generating gas : Ar
- Gas flow rate: 100 sccm
- Duty ratio: 0.5%
- Repetition frequency: 1,000 Hz
- Applied voltage : 0 kV
- RF power source: frequency 13.56 MHz, applied power 1,000 W
- Chamber pressure: 0.2 Pa
- Pulse width: 5 μsec
- Process time (ion implantation time): 5 min
- Conveying speed: 0.2 m/min

In Examples 1 to 5, 7 to 9, 11, and 13 to 20, and Comparative Example 2, element analysis of the film was performed at a depth (from the upper surface) of about 10 nm by means of an XP spectrometer (ULVAC Phi). In all cases, completion of ion implantation was confirmed.
In Example 6, differentiation of nitrogen atoms contained in the silazane compound from the implanted nitrogen ions was difficult. In Examples 10 and 12, implanted ions were not detected through XPS. However, in consideration of the performed operations and confirmation of completion of ion implantation in the other Examples as well as enhancement in gas barrier performance, ion implantation was thought to be completed also in Examples 6, 10, and 12.
The species of the polysilazane compounds employed in the Examples and Comparative Examples, heating

time (min) required for producing each formed product, thickness of the formed layer (nm), plasma-generating gas employed, and application voltage (kV) are collectively given in Table 1.

The transparent conductive films produced in Examples 1 to 20 and Comparative Examples 1 to 3 were measured in terms of water vapor permeability and transmittance (%) at 550 nm. Table 1 shows the results.

Then, the transparent conductive films produced in Examples 1 to 20 and Comparative Examples 1 to 3 were measured in terms of sheet resistivity and variation in sheet resistivity (Ω/square) during the moisture- and heat-resistance test. Table 1 shows the results.

As is clear from Table 1, the transparent conductive films of Examples 1 to 20 exhibited lower water vapor permeability and higher gas barrier performance, as compared with the transparent conductive films of Comparative Examples 1 to 3. Regarding variation in sheet resistivity during the moisture- and heat-resistance test, the transparent conductive films of Examples 1 to 20 exhibited considerably low percent variation, whereas those of Comparative Examples 1 to 3 exhibited considerable elevation in sheet resistivity under moist and hot conditions. Therefore, the combination of gas barrier layer and transparent conductive layer according to the present invention was found to realize remarkably invariable sheet resistivity.

[Table 1]

| | Heating time (min) | Thickness (nm) | Plasma from | Voltage (kV) | Silazane compd. | Fraction (%) | | | Film density ($g/cm^3$) | Transmittance at 550 nm (%) | Water vapor permeability ($g/m^2/day$) | Sheet resistivity (Ω/square) | | | | |
|---|---|---|---|---|---|---|---|---|---|---|---|---|---|---|---|---|
| | | | | | | O atom | N atom | Si atom | | | | Initial: $R_0$ | 60°C, 7 days | $T_1 = (R_1-R_0)/R_0$ | 60°C 90%, RH 7 days: $R_2$ | $T_2 = (R_2-R_0)/R_0$ |
| Ex. 1 | 1 | 60 | Ar | -10 | A | 63.22 | 7.21 | 29.57 | 2.60 | 88.7 | 0.2 | 5.05.E+02 | 5.10.E+02 | 0.01 | 5.15.E+02 | 0.02 |
| Ex. 2 | 5 | 60 | Ar | -10 | A | 63.05 | 5.89 | 31.06 | 3.28 | 88.2 | 0.03 | 5.00.E+02 | 5.10.E+02 | 0.02 | 5.40.E+02 | 0.08 |
| Ex. 3 | 5 | 100 | Ar | -10 | A | 63.21 | 5.69 | 31.10 | 3.37 | 88.6 | 0.01 | 4.90.E+02 | 5.05.E+02 | 0.03 | 5.35.E+02 | 0.09 |
| Ex. 4 | 5 | 150 | Ar | -10 | A | 63.10 | 5.36 | 31.54 | 3.56 | 88.3 | 0.01 | 4.95.E+02 | 5.00.E+02 | 0.01 | 5.30.E+02 | 0.07 |
| Ex. 5 | 20 | 60 | Ar | -10 | A | 63.54 | 5.13 | 31.33 | 3.19 | 88.9 | 0.03 | 5.00.E+02 | 5.10.E+02 | 0.02 | 5.40.E+02 | 0.08 |
| Ex. 6 | 5 | 60 | $N_2$ | -10 | A | 69.51 | 1.40 | 29.09 | 3.32 | 87.5 | 0.04 | 4.95.E+02 | 5.10.E+02 | 0.03 | 5.40.E+02 | 0.09 |
| Ex. 7 | 5 | 60 | Ar | -5 | A | 67.68 | 2.47 | 29.85 | 2.76 | 88.0 | 0.05 | 5.10.E+02 | 5.15.E+02 | 0.01 | 5.25.E+02 | 0.03 |
| Ex. 8 | 5 | 60 | Ar | -15 | A | 69.01 | 0.15 | 30.84 | 3.02 | 88.1 | 0.01 | 5.00.E+02 | 5.15.E+02 | 0.03 | 5.30.E+02 | 0.06 |
| Ex. 9 | 5 | 60 | Ar | -10 | B | 60.58 | 5.21 | 34.21 | 2.54 | 88.5 | 0.07 | 5.15.E+02 | 5.15.E+02 | 0.00 | 5.40.E+02 | 0.05 |
| Ex. 10 | 5 | 60 | $H_2$ | -10 | A | 71.00 | 0.19 | 28.81 | 2.71 | 88.4 | 0.07 | 5.00.E+02 | 5.10.E+02 | 0.02 | 5.25.E+02 | 0.05 |
| Ex. 11 | 5 | 60 | $O_2$ | -10 | A | 68.21 | 2.22 | 29.57 | 3.15 | 87.9 | 0.05 | 5.00.E+02 | 5.10.E+02 | 0.02 | 5.25.E+02 | 0.05 |
| Ex. 12 | 5 | 60 | He | -10 | A | 71.60 | 0.68 | 27.72 | 2.63 | 88.0 | 0.05 | 5.00.E+02 | 5.20.E+02 | 0.04 | 5.30.E+02 | 0.06 |
| Ex. 13 | 5 | 60 | Ne | -10 | A | 70.22 | 1.67 | 28.11 | 2.70 | 88.3 | 0.05 | 5.15.E+02 | 5.15.E+02 | 0.00 | 5.25.E+02 | 0.02 |
| Ex. 14 | 5 | 60 | Xe | -10 | A | 65.82 | 4.73 | 29.45 | 2.91 | 87.9 | 0.07 | 5.10.E+02 | 5.20.E+02 | 0.02 | 5.50.E+02 | 0.08 |
| Ex. 15 | 5 | 60 | Kr | -10 | A | 66.80 | 3.59 | 29.61 | 2.89 | 88.4 | 0.08 | 4.95.E+02 | 5.15.E+02 | 0.04 | 5.35.E+02 | 0.08 |
| Ex. 16 | 1 | 60 | Ar | -10 | A | 63.22 | 7.21 | 29.57 | 2.60 | 83.2 | 0.12 | 4.90.E+02 | 5.20.E+02 | 0.06 | 5.40.E+02 | 0.10 |
| Ex. 17 | 1 | 60 | Ar | -10 | A | 63.12 | 7.35 | 29.53 | 2.58 | 88.0 | 0.08 | 5.40.E+01 | 5.50.E+01 | 0.02 | 6.00.E+01 | 0.11 |
| Ex. 18 | 1 | 60 | Ar | -10 | A | 63.33 | 7.29 | 29.38 | 2.62 | 89.5 | 0.12 | 5.40.E+01 | 5.60.E+01 | 0.02 | 6.20.E+01 | 0.13 |
| Ex. 19 | 1 | 60 | Ar | -10 | A | 62.81 | 7.11 | 30.08 | 2.63 | 89.3 | 0.09 | 6.20.E+01 | 6.20.E+01 | 0.00 | 9.00.E+01 | 0.45 |
| Ex. 20 | 1 | 60 | Ar | -10 | A | 63.54 | 7.21 | 29.25 | 2.67 | 90.8 | 0.13 | 6.80.E+01 | 6.90.E+01 | 0.01 | 8.20.E+01 | 0.21 |
| Comp. Ex. 1 | 1 | 60 | - | - | A | 63.32 | 4.20 | 32.48 | 1.63 | 88.4 | 10.32 | 5.00.E+02 | 2.40.E+03 | 3.80 | 2.10.E+04 | 41.00 |

(continued)

| | Heating time (min) | Thickness (nm) | Plasma from | Voltage (kV) | Silazane compd. | Fraction (%) | | | Film density ($g/cm^3$) | Transmittance at 550 nm (%) | Water vapor permeability ($g/m^2/day$) | Sheet resistivity (Ω/square) | | | | |
|---|---|---|---|---|---|---|---|---|---|---|---|---|---|---|---|---|
| | | | | | | O atom | N atom | Si atom | | | | Initial: $R_0$ | 60°C, 7 days | $T_1 = (R_1-R_0)/R_0$ | 60°C 90%, RH 7 days: $R_2$ | $T_2 = (R_2-R_0)/R_0$ |
| Comp. Ex. 2 | - | - | Ar | -10 | - | - | - | - | 1.51 | 88.3 | 7.98 | 5.10.E+02 | 9.00.E+02 | 0.76 | 3.60.E+04 | 69.59 |
| Comp. Ex. 3 | 5 | 60 | Ar | 0 | A | 57.11 | 12.86 | 30.03 | 2.21 | 88.6 | 12.58 | 5.00.E+02 | 3.20.E+03 | 5.40 | 2.80.E+04 | 55.00 |
| E+n=×$10^N$ | | | | | | | | | | | | | | | | |

Industrial Applicability

The transparent conductive film of the present invention is suitably employed as a flexible display member or an electronic device member such as a solar battery back sheet.

According to the production method of the present disclosure, transparent conductive film products having excellent gas barrier performance and falling within the scope of the present invention can be produced with safety in a simple manner.

By virtue of excellent gas barrier performance and transparency, the transparent conductive film of the present invention is suitably used in a display or an electronic device such as a solar battery.

Description of Reference Numerals

| | |
|---|---|
| 1a, 1c | film |
| 1b, 1d | film |
| 2a, 2b | high-voltage application rotatable can |
| 3a, 3b | unwinding roller |
| 4 | plasma discharge electrode |
| 5a, 5b | winding roller |
| 6a, 6b | feed roller |
| 7a, 7b | high-voltage pulse power source |
| 9a, 9b··· | high-voltage pulse |
| 10a, 10b··· | gas inlet |
| 11a, 11b··· | chamber |
| 13··· | center axis |
| 15··· | high-voltage-introduction terminal |
| 20a, 20b··· | turbo molecular pump |
| 100··· | transparent conductive film |
| 110··· | substrate |
| 120··· | gas barrier layer |
| 121··· | ion implantation region |
| 130··· | transparent conductive layer |

**Claims**

1. A transparent conductive film (100), comprising:

   a substrate (110) and,
   formed on at least one surface of the substrate (110), a gas barrier layer (120) having a polysilazane compound content of 50 wt.% or more, and a transparent conductive layer (130), wherein
   the gas barrier layer (120) is formed by coating a layer-forming solution containing the polysilazane compound on the substrate and by heating it,
   wherein the gas barrier layer (120)

      includes, on its side opposite to the one surface of the substrate (110), a surface layer part (121) such as to extend from the surface of the gas barrier layer (120) in the direction towards the substrate to a depth of 5 nm, to have, as analyzed by X-ray photoelectron spectroscopy, XPS, an oxygen atom fraction of 60 to 75%, a nitrogen atom fraction of 0 to 10%, and a silicon atom fraction of 25 to 35%, each atom fraction being calculated with respect to the total number of the oxygen atoms, nitrogen atoms, and silicon atoms contained in the surface layer part (121) of the gas barrier layer (120), and to have a film density of 2.4 to 4.0 g/$cm^3$, and
      has a water vapor permeability less than 0.35 g/$m^2$/day as measured in an atmosphere at 40°C and a relative humidity of 90%.

2. The transparent conductive film (100) according to claim 1, wherein the polysilazane compound is perhydropolysilazane.

**3.** The transparent conductive film (100) according to claim 1 or 2, wherein the transparent conductive layer (130) is formed of a metal oxide.

**4.** The transparent conductive film (100) according to claim 3, wherein the metal oxide is an indium-based oxide containing indium oxide as a main ingredient in an amount of 90 mass% or more or a zinc-based oxide containing zinc oxide as a main ingredient in an amount of 90 mass% or more.

**5.** The transparent conductive film (100) according to claim 1, wherein the polysilazane compound is a polyorgano(hydro)silazane compound according to the molecular structure formula:

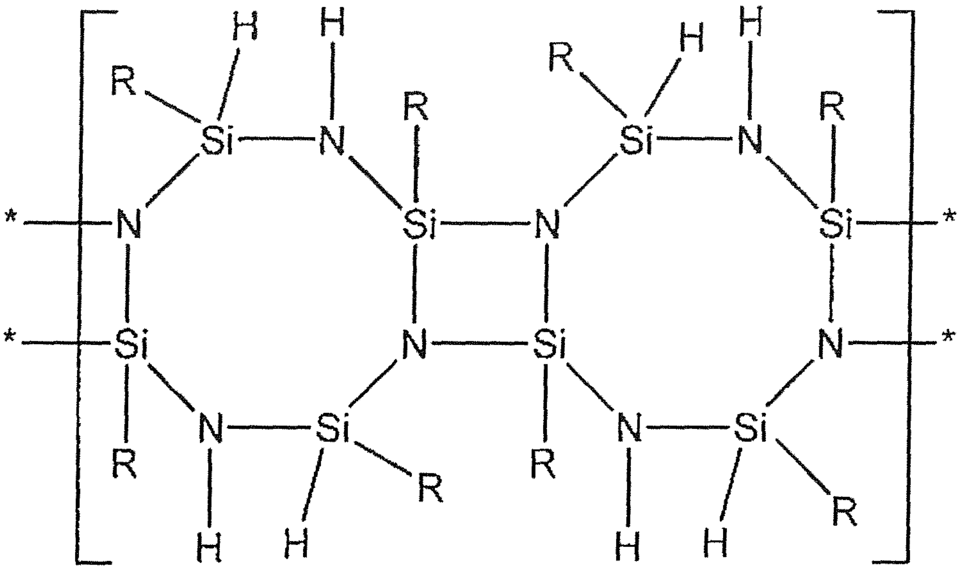

where $R=CH_3$.

**6.** The transparent conductive film (100) according to claim 1, wherein the polysilazane compound is a low-temperature sintered polysilazane to which a catalyst compound for promoting sintering of polysilazane has been added.

**7.** An electronic device employing a transparent conductive film as recited in any one of the claims 1 to 4.

**Patentansprüche**

**1.** Transparenter leitender Film (100), umfassend:

ein Substrat (110) und,
gebildet auf mindestens einer Oberfläche des Substrats (110), eine Gasbarriereschicht (120) mit einem Polysilazan-Verbindungsanteil von gewichtsmäßig 50% oder mehr und eine transparente leitende Schicht (130), wobei
die Gasbarriereschicht (120) durch Beschichten des Substrats mit einer schichtbildenden Lösung, die die Polysilazan-Verbindung enthält, und Erhitzen derselben gebildet wird,
wobei die Gasbarriereschicht (120)

auf ihrer der einen Oberfläche des Substrats (110) gegenüberliegenden Seite einen Oberflächenschichtanteil (121) enthält, sodass dieser von der Oberfläche der Gasbarriereschicht (120) in der Richtung zum Substrat hin bis zu einer Tiefe von 5 nm verläuft, gemäß Röntgenphotoelektronenspektroskopie- oder XPS-Analyse einen Sauerstoffatomanteil von 60 bis 75%, einen Stickstoffatomanteil von 0 bis 10% und einen Siliziumatomanteil von 25 bis 35% aufweist, wobei jeder Atomanteil in Bezug auf die Gesamtanzahl der im Oberflächenschichtanteil (121) der Gasbarriereschicht (120) enthaltenen Sauerstoffatome, Stickstoffatome und Siliziumatome berechnet wird, und eine Filmdichte von 2,4 bis 4,0 g/$cm^3$ aufweist, und
eine Wasserdampf-Permeabilität von weniger als 0,35 g/$m^2$/Tag gemessen in einer Atmosphäre von 40°C

und einer relativen Feuchtigkeit von 90% aufweist.

2. Transparenter leitender Film (100) nach Anspruch 1, wobei die Polysilazanverbindung Perhydropolysilazan ist.

3. Transparenter leitender Film (100) nach Anspruch 1 oder 2, wobei die transparente leitende Schicht (130) aus einem Metalloxid gebildet ist.

4. Transparenter leitender Film (100) nach Anspruch 3, wobei das Metalloxid ein Indium-basiertes Oxid, das Indiumoxid als Hauptbestandteil mit einer Menge von massenmäßig 90% oder mehr enthält, oder ein Zink-basiertes Oxid, das Zinkoxid als einen Hauptbestandteil mit einer Menge von massenmäßig 90% oder mehr enthält, ist.

5. Transparenter leitender Film (100) nach Anspruch 1, wobei die Polysilazanverbindung eine Polyorgano(hydro)silazan-Verbindung gemäß der folgenden Molekularstrukturformel ist:

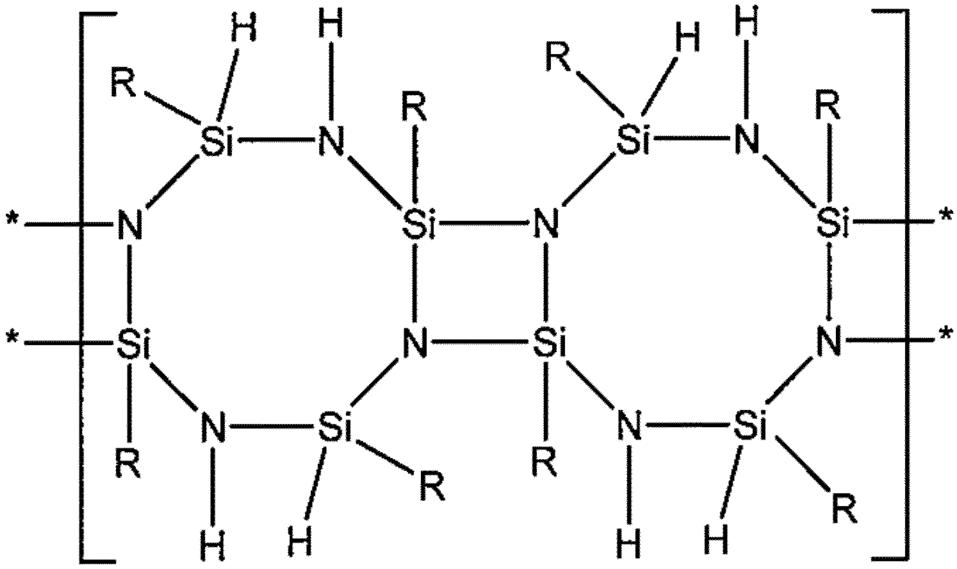

wobei R=CH3.

6. Transparenter leitender Film (100) nach Anspruch 1, wobei die Polysilazan-Verbindung ein bei niedriger Temperatur gesintertes Polysilazan ist, dem eine Katalysatorverbindung zum Begünstigen des Sinterns des Polysilazan hinzugefügt worden ist.

7. Elektronische Vorrichtung, bei der ein transparenter leitender Film nach einem der Ansprüche 1 bis 4 eingesetzt ist.

## Revendications

1. Film conducteur transparent (100), comprenant :

un substrat (110) et,
formée sur au moins une surface du substrat (110), une couche de barrière aux gaz (120) ayant une teneur en composé polysilazane de 50% en poids ou plus, et une couche conductrice transparente (130), dans lequel la couche de barrière aux gaz (120) est formée en déposant une solution de formation de couche contenant le composé polysilazane sur le substrat et en la chauffant,
dans lequel la couche de barrière aux gaz (120)

inclut, sur son côté opposé à l'une surface du substrat (110), une partie de couche de surface (121) telle que de manière à s'étendre de la surface de la couche de barrière aux gaz (120) dans la direction vers le substrat jusqu'à une profondeur de 5 nm, pour avoir, telles qu'analysées par spectroscopie photoélectronique par rayons X, XPS, une fraction d'atomes d'oxygène de 60 à 75%, une fraction d'atomes d'azote de

0 à 10%, et une fraction d'atomes de silicium de 25 à 35%, chaque fraction d'atomes étant calculée par rapport au nombre total des atomes d'oxygène, des atomes d'azote, et des atomes de silicium contenus dans la partie de couche de surface (121) de la couche de barrière aux gaz (120), et pour avoir une densité de film de 2,4 à 4,0 g/$cm^3$, et
a une perméabilité à la vapeur d'eau inférieure à 0,35 g/$m^2$/jour telle que mesurée dans une atmosphère à 40°C et une humidité relative de 90%.

**2.** Film conducteur transparent (100) selon la revendication 1, dans lequel le composé polysilazane est un perhydropolysilazane.

**3.** Film conducteur transparent (100) selon la revendication 1 ou 2, dans lequel la couche conductrice transparente (130) est constituée d'un oxyde de métal.

**4.** Film conducteur transparent (100) selon la revendication 3, dans lequel l'oxyde de métal est un oxyde à base d'indium contenant de l'oxyde d'indium comme un ingrédient principal dans une quantité de 90% en masse ou plus ou un oxyde à base de zinc contenant de l'oxyde de zinc comme un ingrédient principal dans une quantité de 90% en masse ou plus.

**5.** Film conducteur transparent (100) selon la revendication 1, dans lequel le composé polysilazane est un composé polyorgano(hydro)silazane selon la formule de structure moléculaire :

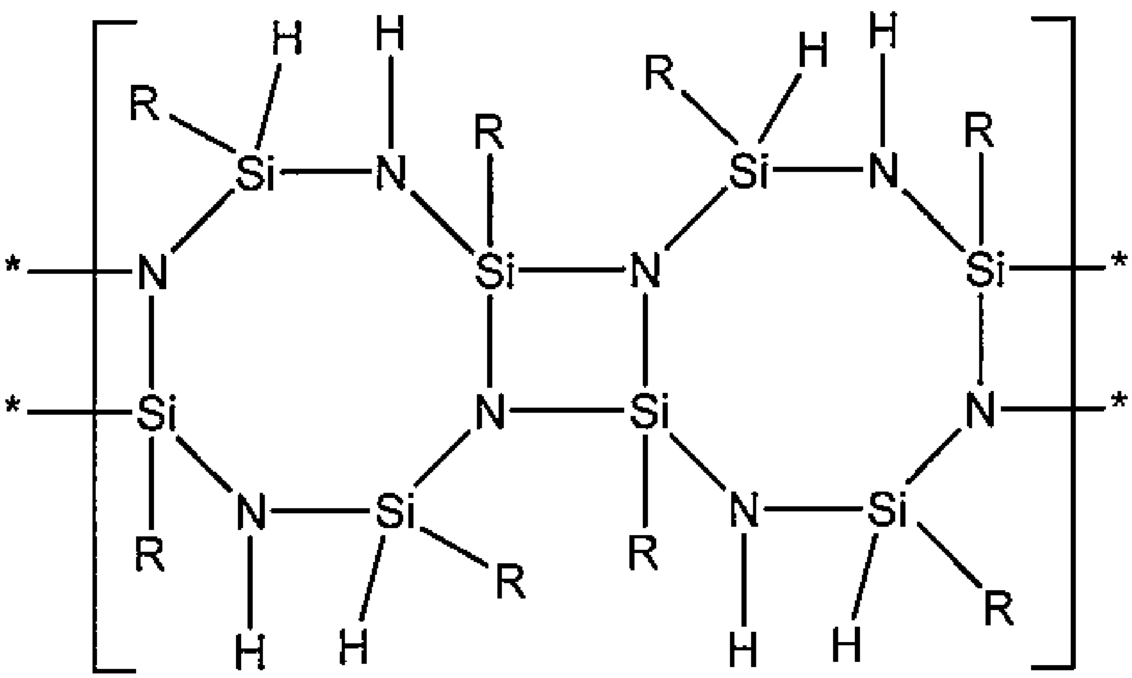

où R=$CH_3$.

**6.** Film conducteur transparent (100) selon la revendication 1, dans lequel le composé polysilazane est un polysilazane fritté à basse température auquel un composé catalyseur pour favoriser le frittage de polysilazane a été ajouté.

**7.** Dispositif électronique employant un film conducteur transparent selon l'une quelconque des revendications 1 à 4.

FIG. 1

(a)

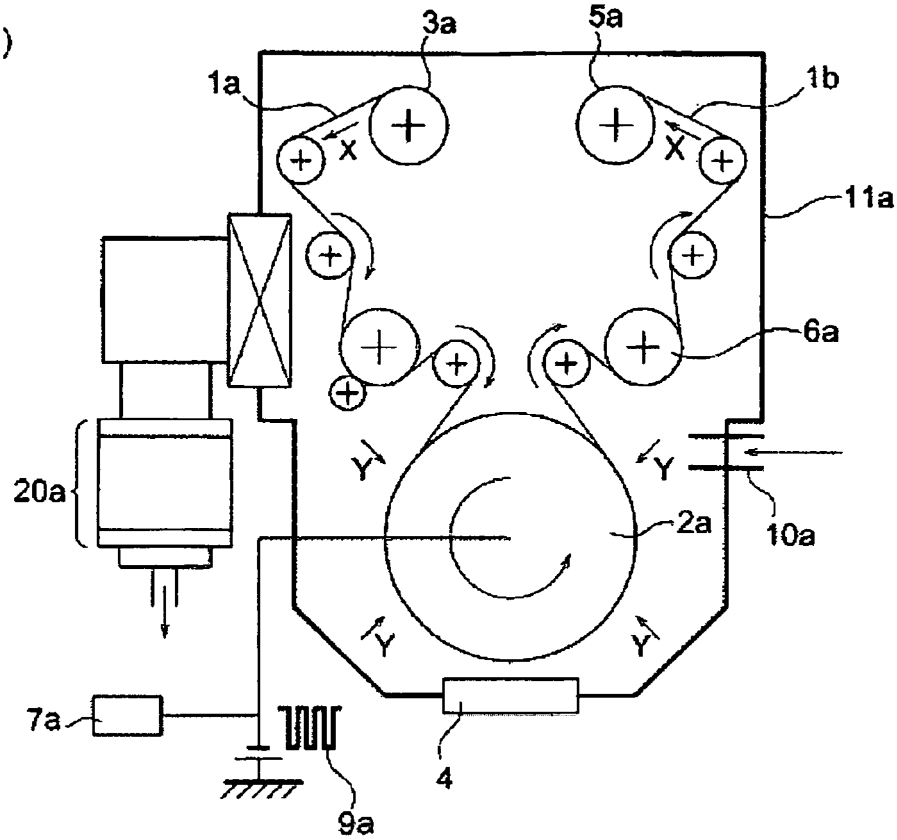


(b)

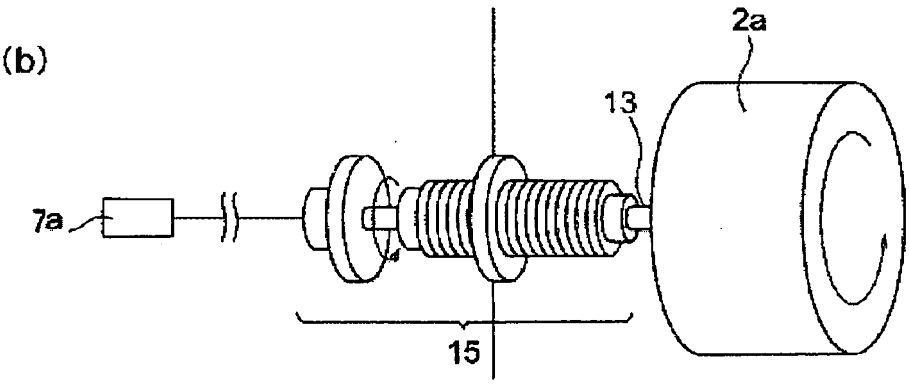

FIG. 2

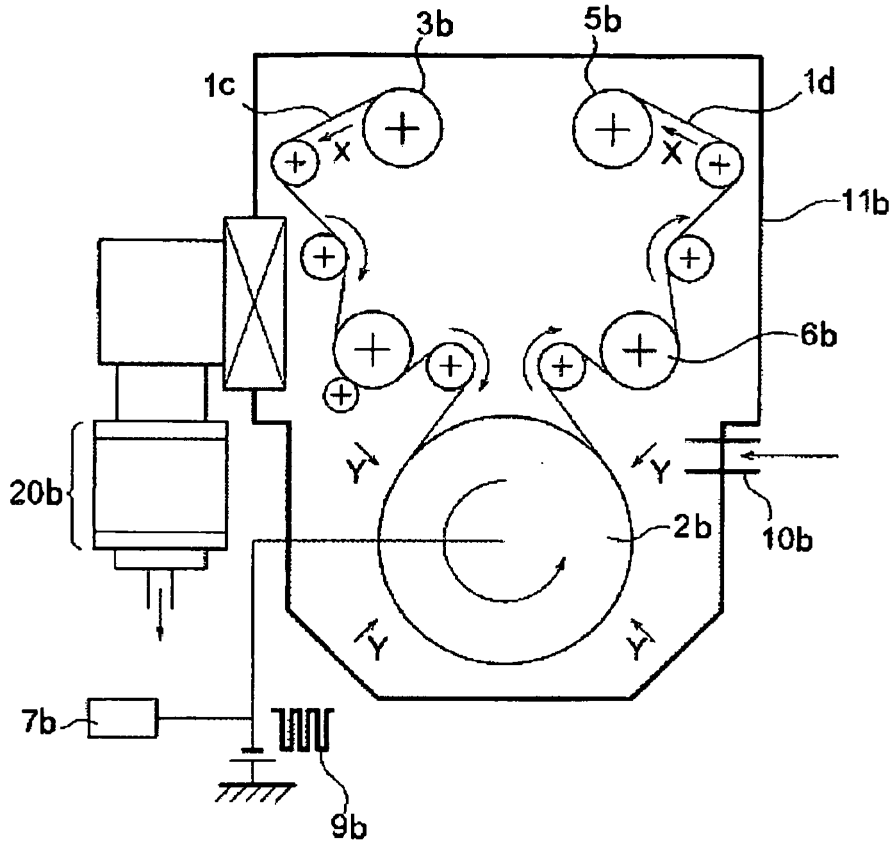


FIG. 3

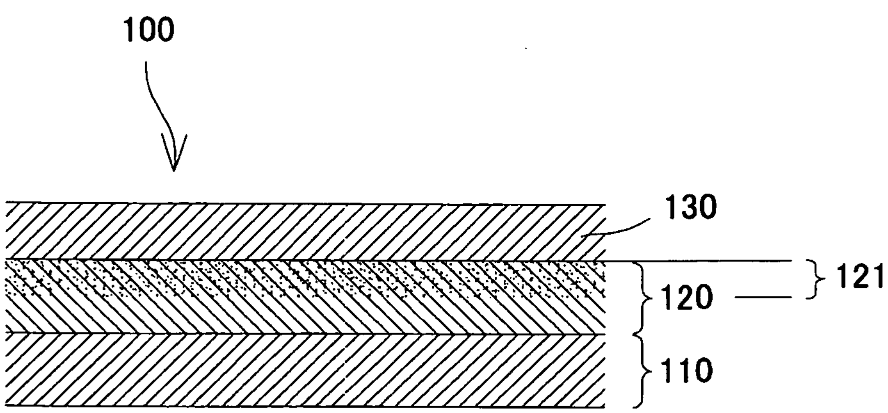

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000338901 A
- JP 2007237588 A
- JP HEI845452 B
- JP HEI6187833 B
- JP 2009199812 A
- JP 2009110897 A
- US 5907382 A
- JP 2010064303 A
- JP SHO62195024 B
- JP HEI284437 B
- JP SHO6381122 B
- JP HEI1138108 B
- JP HEI2175726 B
- JP HEI5238827 B
- JP HEI6122852 B
- JP HEI6306329 B
- JP HEI6299118 B
- JP HEI931333 B
- JP HEI5345826 B
- JP HEI463833 B
- JP HEI9143289 B
- JP 2001026887 A
- JP 2001156013 A


### Non-patent literature cited in the description


- *APPLIED PHYSICS LETTERS,* 2006, vol. 89, 091904
- **S. IWAMORI et al.** Characterization of silicon oxynitride gas barrier films. *Vacuum,* 2003, vol. 68, 113-117